Europäisches Patentamt

(19) European Patent Office

Office européen des brevets

(11) EP 0 911 964 A1

(12) EUROPEAN PATENT APPLICATION

(43) Date of publication:
28.04.1999 Bulletin 1999/17

(51) Int. Cl.⁶: H03F 3/08

(21) Application number: 98119378.2

(22) Date of filing: 14.10.1998

(84) Designated Contracting States:
AT BE CH CY DE DK ES FI FR GB GR IE IT LI LU MC NL PT SE
Designated Extension States:
AL LT LV MK RO SI

(30) Priority: 20.10.1997 JP 287288/97

(71) Applicant: NEC CORPORATION
Tokyo (JP)

(72) Inventor: Tachigori, Masashi
Minato-ku, Tokyo (JP)

(74) Representative:
VOSSIUS & PARTNER
Siebertstrasse 4
81675 München (DE)

(54) Optical receiver circuit

(57) An optical receiver includes a photodetector for converting an input optical signal into photocurrent. A first transistor has a first resistor which is connected to its collector and receives a photocurrent from the photodetector as an input. A second transistor has its base connected to the collector of the first transistor, and a level shift circuit and a second resistor are connected in series to an emitter of the second transistor. A feedback resistor is connected to a point between the level shift circuit and the second resistor and to a base of the first transistor, an output stage transistor has its base connected to the emitter of the second transistor, and a load resistor is connected to an emitter of the output stage transistor. A diode is connected to the first resistor in parallel.

## Figure1

## Description

The present invention relates to an optical receiver in an optical transmission system, and in particular to an optical reciever circuit for avoiding saturation even when a high power optical signal is inputted.

In order to realize a practical optical tranmission system, optical receivers with high sensitivity are required. An optical receiver comprises in general a photodetector, preamplifier, postamplifier, decision circuit and preferably a clock extraction circuit. To obtain a high sensitivity receiver, these components are carefully selected or designed. In particular, a preamplifier should meet several requirements, such as low noise, high transimpedance gain and highly stable operation without oscillation. Also, a preamplifier should have a large dynamic range for input optical signal power, to tolerate input power fluctuation and to obtain a large system power margin.

For this purpose, several circuit structures for optical receivers have been proposed. One of such structures comprises a transistor amplifier with a feedback loop as a photocurrent-to-voltage converted. To avoid amplifier saturation, a diode is inserted in parallel to the feedback resistor. However, several disadvantages can be pointed out concerning this configuration as follows:

(1) For large power optical input, the voltage drop in the diode saturates to some constant value. In this case, the feedback resistance becomes correspondingly smaller, which leads to feedback circuit instability.

(2) Parasitic capacitance in the diode is transferred to the amplifier input, that is, the transistor base. With this capacitance, noise may increase and gain-frequency characteristic may deteriorate.

In view of the foregoing and other problems of the conventional optical receivers, an object of the present invention is to provide an optical receiver circuit with reduced saturation, even when receiving a high power optical input, so as to realize constantly stable operation.

In a first aspect of the present invention, an inventive optical receiver is provided which includes a photodetector which converts an input optical signal to a photocurrent, a first transistor whose base is disposed so as to receive the photocurrent, a first resistor which is connected to the collector of the first transistor, a diode circuit comprising one diode or a plurality of series-connected diodes, which is connected in parallel to the first resistor, a second transistor whose base is connected to the collector of the first transistor, a level shift circuit whose first terminal is connected to the emitter of the second transistor, a second resistor which is connected to a second terminal of the level shift circuit, and a feedback resistor whose two terminals are connected to the base of the first transistor and the second terminal of the level shift circuit, respectively.

Additionally, an optical receiver of the present invention may further include a third transistor whose base is connected to the emitter of the second transistor and a third resistor which is connected to the emitter of the third transistor.

Further, the photodetector preferably includes either a PIN photodiode or an avalanche photodiode.

Further, the level shift circuit may include either a second diode or a fourth resistor.

The diode circuit may further include a resistor.

Further, instead of using bipolar transistors, the first, second and third transistors may be FETs.

In a second aspect of the present invention, an inventive optical receiver is provided with a photodetector which converts an input optical signal to a photocurrent, a first transistor whose base is disposed so as to receive the photocurrent, a first resistor which is connected to the collector of the first transistor, a first diode which is connected in parallel to the first resistor, a second transistor whose base is connected to the collector of the first transistor, a level shift circuit whose first terminal is connected to the emitter of the second transistor, a second resistor which is connected to a second terminal of the level shift circuit, a feedback resistor whose two terminals are connected to the base of the first transistor and the second terminal of the level shift circuit, respectively, a third transistor whose base is connected to the emitter of the second transistor, a third resistor which is connected to the emitter of the third transistor, and a current source with its output current provided for the third resistor, wherein reference current for the current source is adjustable using a variable resistor.

Further, the current source may preferably include a current mirror circuit.

Further, the level shift circuit may include either a second diode or a fourth resistor.

The diode circuit may further include a resistor.

In a third aspect of the present invention, an inventive optical receiver is provided with a photodetector which converts an input optical signal to a photocurrent, a first transistor whose base is disposed so as to receive the photocurrent, a first resistor which is connected to the collector of the first transistor, a first diode which is connected in parallel to the first resistor, a second transistor whose base is connected to the collector of the first transistor, a level shift circuit whose first terminal is connected to the emitter of the second transistor, a second resistor which is connected to a second terminal of the level shift circuit, a feedback resistor whose two terminals are connected to the base of the first transistor and the second terminal of the level shift circuit, respectively, a third transistor whose base is connected to the emitter of the second transistor, a third resistor which is connected to the emitter of the third transistor, and a differential amplifier comprising two emitter-coupled transistors and a current source connected to a connection point of the coupled emitters, wherein two input terminals are connected to the emitter of the third transistor and reference voltage source.

Further, the current source may preferably include a current mirror circuit.

Further, each of two emitters of the emitter-coupled transistors may be connected via at least one resistor to the connection point.

Further, the level shift circuit may include either a second diode or a fourth resistor.

The diode circuit may further include a resistor.

BRIEF DESCRIPTION OF THE DRAWINGS

The above and other objects, features and advantages of the present invention will become more apparent from the following detailed description when taken in conjunction with the accompanying drawings wherein:

Figure 1 shows an optical receiver structure of the first embodiment according to the present invention;

Figure 2 shows the frequency characteristics for preamplifier transimpedance, open-loop gain and gain of the core amplifier without feedback, all of which are for the first embodiment;

Figure 3 shows an optical receiver structure of the second embodiment according to the present invention;

Figure 4 shows an optical receiver structure of the third embodiment according to the present invention;

Figure 5 shows an optical receiver structure of the fourth embodiment according to the present invention;

Figure 6 shows the circuit structure for a conventional optical receiver circuit;

Figure 7 shows the circuit structure for a modified conventional optical receiver circuit; and

Figure 8 shows the frequency characteristics for preamplifier transimpedance, open-loop gain and gain of the core amplifier without feedback, all of which are for the modified conventional optical receiver.

DETAILED DESCRIPTION OF THE PREFERRED EMBODIMENTS

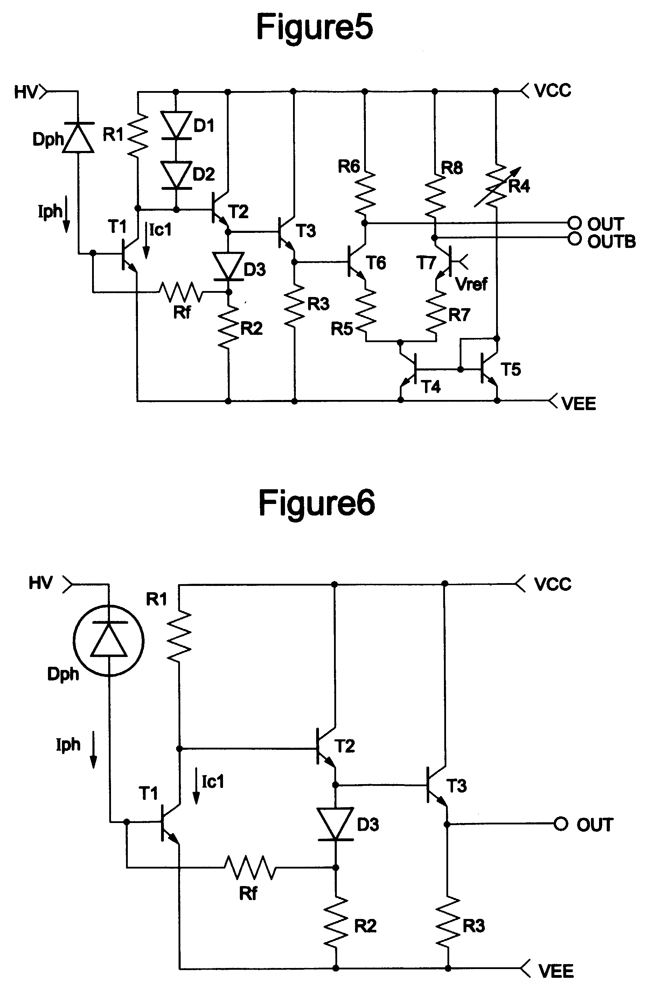

Before explaining preferred embodiments according to the present invention, a description of the related optical receivers will be given, to make the present invention easily understandable. There has been proposed an optical receiver circuit as shown in Fig. 6.

In this optical receiver circuit, an inputted optical signal is converted into a photocurrent Iph at a photodiode Dph. The photocurrent Iph flows through a feedback resistor Rf into a core amplifier composed of transistors T1 and T2 so that Iph can be converted into a voltage signal. The voltage signal obtained by the conversion is outputted from an emitter of a transistor T3.

The above-mentioned optical receiver circuit has the following drawback. When the photocurrent Iph increases with a high power optical signal, a voltage drop at the feedback resistor Rf increases. With the increasing voltage drop, the voltage at the connection point of the diode D3, the resistor R2 and the feedback resistor Rf approximates the reference voltage VEE. At this time, collector electric current Ic1 of the transistor T1 will increase. When the voltage Vce between collector and emitter of the transistor T1 finally saturates with increasing voltage drop in the resistor R1 according to the increase in the Ic1, the optical receiver circuit will lose normal operation.

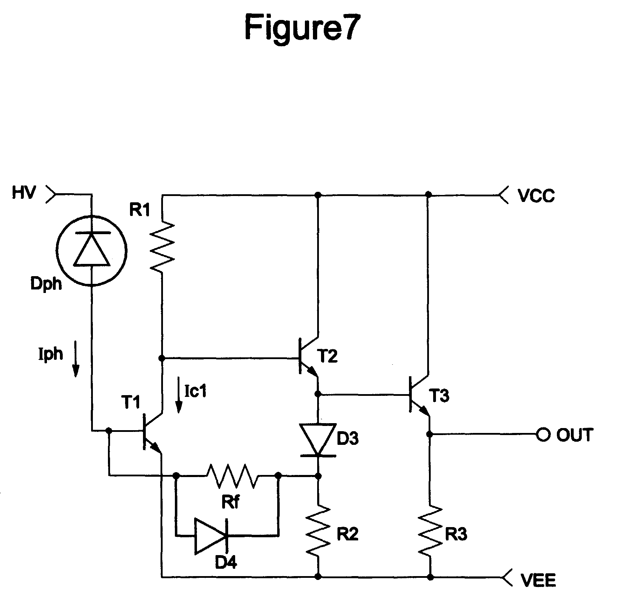

In order to avoid this saturation, there has been another proposal of connecting a diode D4 in parallel with the feedback resistor Rf for restricting voltage drop of Rf, as illustrated in Fig. 7. In this optical receiver, when the voltage drop due to the photocurrent Iph flowing across the feedback resistor Rf satisfies the relationship $Rf \times Iph > Vf(D4)$, wherein $Vf(D4)$ denotes forward voltage of the diode D4, the voltage drop in the parallel circuit of Rf and D4 is fixed to the value $Vf(D4)$. Therefore, since the voltage drop of the parallel circuit is restricted, the saturation problem can be avoided.

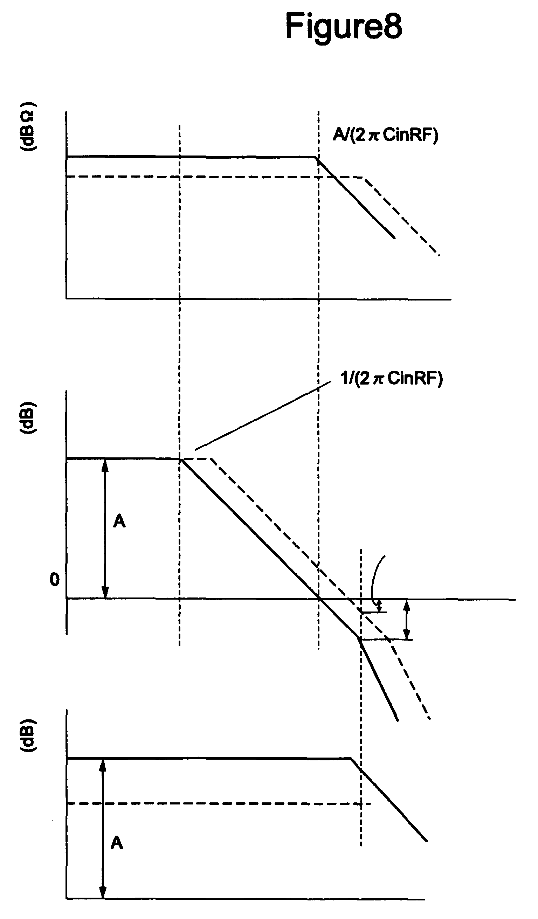

However, the optical receiver shown in Fig. 7 has the following drawbacks. Namely, in this circuit, the voltage drop becomes unchanged when receiving a high power optical input. In consequence, the resistance for the feedback resistor Rf decreases correspondingly. This will result in unstable operation of the feedback circuit. Figure 8 shows the frequency characteristic of a transimpedance, an open loop gain and a core amplifier gain without feedback, all of which are for the optical receiver shown in Fig.7. In general, a gain margin at the frequency of the first pole of the core amplifier open-loop gain is one index describing stability of the core amplifier with feedback. When the feedback resistance Rf becomes correspondingly smaller, the zero cross point of the open loop gain determined by $A/(2\pi CinRf)$ is shifted to a high frequency band, and approaches the first pole of the core amplifier gain without feedback so that the gain margin will be lost. Under diminished gain margin, the optical receiver will more readily oscillate.

Furthermore, the added diode D4 also adds a capacitance component to the base of the first transistor T1. This newly connected capacitor has a bad influence on the gain and noise characteristics of the optical receiver.

Embodiments of the present invention will now be explained in detail, referring to the figures.

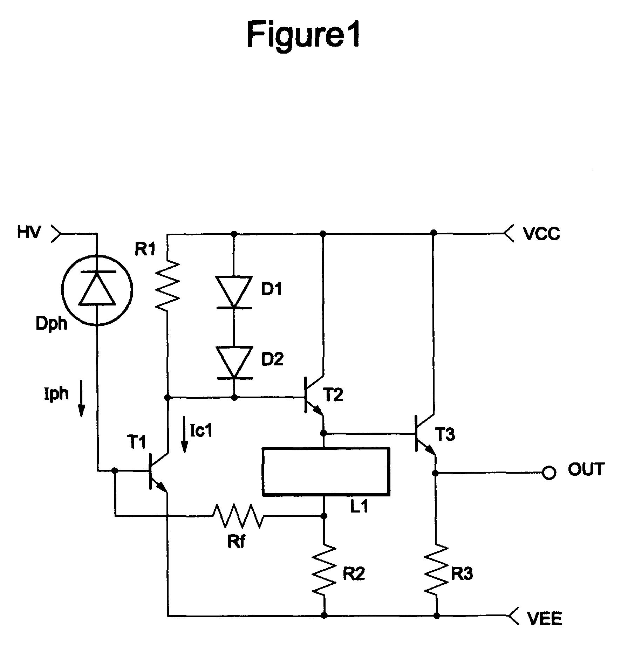

In Figure 1, Dph represents a photosemiconductor, such as a pin-photodiode (PIN-PD) or an avalanche photodiode (APD), for carrying out opto-electric current conversion.

A core amplifier is composed of the first transistor T1, a resistor R1, a transistor T2 whose base is connected to a point between the transistor T1 collector and the resistor R1, a level shift circuit L1 which is connected to the emitter of the transistor T2, and a resistor R2.

An output circuit is composed of an emitter follower circuit comprising a transistor T3 whose base is connected to the emitter of the transistor T2, and a resistor R3 which is connected to the emitter of the transistor T3.

A feedback resistor Rf connects the first transistor T1 base and a connection point of the level shift circuit L1 and the resistor R2.

Diodes D1 and D2 for preventing saturation in when receiving a high power optical input are disposed between the power supply VCC voltage and the collector of the transistor T1.

In Fig. 1, when the voltage drop in the R1 based on increase in the collector current Ic1 when receiving a high power optical input satisfies Ic1 x R1 > Vf(D1) + Vf(D2) , the diodes D1 and D2 fix Ic1 x R1 to Vf(D1) + Vf(D2) so as to prevent saturation of Vce of the transistor T1. The number of D1 and D2 is not limited by the voltage drop based on increase in the collector current Ic1 in receiving large input. In other words, the number of the diode(s) may instead be one or three. Furthermore, combination of at least one diode and a resistor can be employed. The level shift circuit L1 is composed of a diode or a resistor.

With the above-mentioned circuit, even when receiving a high power optical input, the diodes D1 and D2 keep the collector voltage of the transistor T1 unchanged so as to maintain the required Vce voltage of the transistor T1, thereby preventing saturation. Therefore, it becomes possible to maintain stable operation when receiving a high power optical input.

The operation of the optical receiver circuit of Fig. 1 will now be explained.

First, an inputted light signal is converted into a photocurrent Iph by the photosemiconductor Dph. The photocurrent Iph flows through the feedback resistor Rf into the core amplifier to be subjected to current-to-voltage conversion. The converted voltage signal is outputted from the emitter of the transistor T3. In this optical receiver, when the photocurrent Iph is small, the voltage difference generated by the photocurrent Iph and the feedback resistor Rf is outputted via the emitter follower circuit.

In the case of receiving a high power optical input, when the collector current Ic1 of the transistor T1 increases to satisfy Ic1 x R1 > Vf(D1) + Vf(D2) , the collector voltage of the transistor T1 is fixed to Vf(D1) + Vf(D2) . For this reason, Vce at the transistor T1 is kept unchanged so that stable operation is possible without saturation, thereby fixing the output voltage.

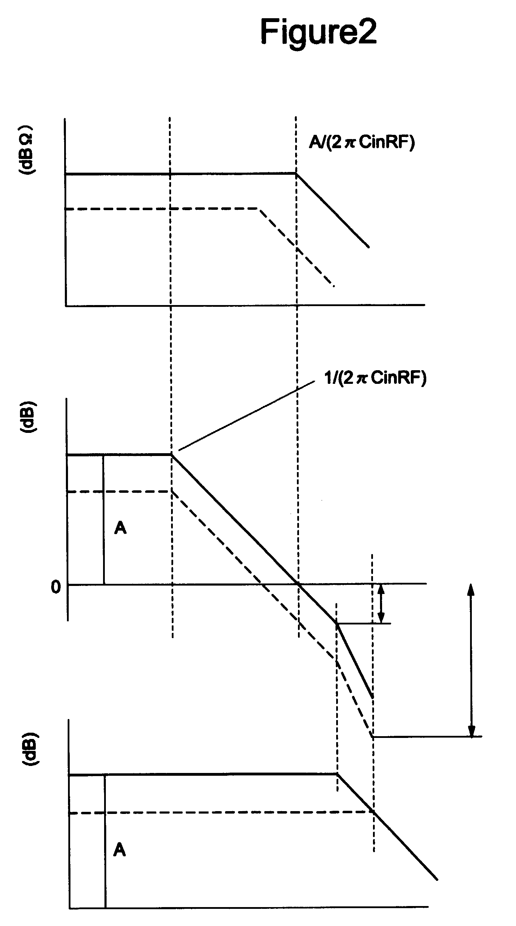

Furthermore, at this time respective characteristics are shifted such that the gain margin indicating stability of the feedback circuit is enlarged. As shown in Figure 2, when receiving a high power optical input, the voltage drop in R1 remains unchanged, which correspondingly increases the gain reduction of the core amplifier without feedback. Accordingly, the first pole for the core amplifier gain without feedback is shifted to a high frequency region. At the same time the open-loop gain of the core amplifier shown in Fig.2 decreases, so that the zero cross point of the open-loop gain is shifted to a low frequency region. Therefore, the gain margin indicating stability of the feedback circuit increases, to reduce occurence of malfunction.

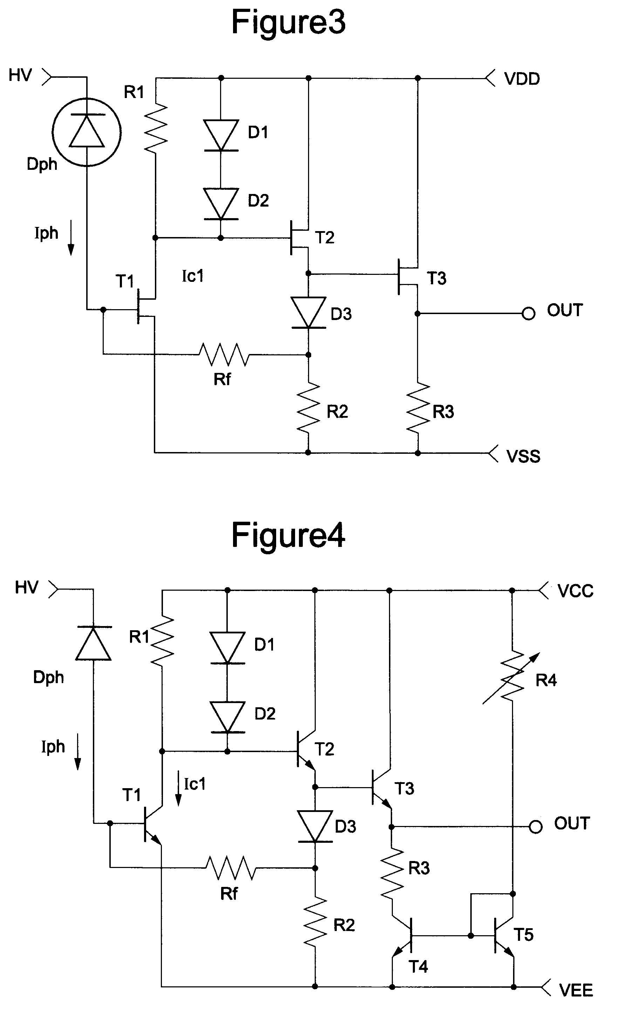

Other embodiments of the optical receiver circuit according to the present invention will now be explained, referring to the figures. Figure 3 illustrates a second embodiment in which FET transistors are used in the optical receiver circuit shown in Fig. 1. Its operation is the same as that in Fig. 1. This embodiment shown in Fig. 3 illustrates the case in which the level shift circuit L1 consists of a diode D3.

Figure 4 illustrates a third embodiment in which a current mirror circuit is added for controlling the electric current of an emitter follower circuit of an output stage. In this circuit structure, as shown in Fig. 4, to the optical receiver circuit shown in Fig. 1 two transistors T4 and T5 are added which constitute a mirror circuit in which its collector is connected to one end of a load resistor R3, the other end of which is connected to the emitter of the output stage transistor T3, and their bases are connected to each other. A variable resistor R4 between the collector of the transistor T5 and the power supply VCC is also added to the optical receiver circuit of Fig. 1. By this, the present amplifier circuit makes driving capacity variable in accordance with the driving load impedance.

Figure 5 illustrates a fourth embodiment in which a single-balance conversion circuit is added to an emitter follower circuit of an output stage. This circuit structure has two transistors T6 and T7, resistors R6 and R8 connected to respective collectors thereof, and resistors R5 and R7 connected to respective emitters thereof. The base of one transistor T6 is connected to the emitter of an output stage transistor T3, the base of the other transistor T7 is connected to a reference power supply Vref, and the other ends of the resistors R5 and R7 are connected to a mirror circuit. This single-balance conversion circuit is connected to the output stage transistor T3, thereby obtaining two complementary outputs.

In the second, third and fourth embodiments, as in the first embodiment, two diodes (D1 and D2) are connected in parallel to R1. However, the number of series-connected diodes is not restricted to two. The number can be increased or decreased. Furthermore, instead of diodes(s), a combination of a resistor and at least one diode can be employed.

For the level shift circuit, a resistor or a diode can also be used for the second through fourth embodiments.

As described above, in the above embodiments according to the present invention, when receiving a high power optical input, D1 and D2 can keep the collector voltage of the transistor T1 constant and maintain the required Vce voltage of the transistor T1 and consequently saturation can be prevented. The following advantageous effects are also obtained:

(1) It is possible to keep a constant output voltage when receiving a high power optical input by the diodes D1 and D2 and keep output signal amplitude unchanged;

(2) The action in receiving a high power optical input is for reducing the gain of the core amplifier, so that the frequency bandwidth of the core amplifier is enlarged and a frequency bandwidth for transimpedance gain is reduced. For this reason, respective poles are separated from each other to improve stability as a feedback circuit; and

(3) Because of the operation described in (2), a stable circuit can be realized only by considering stability under normal input power operation, so that it becomes easy to design a feedback circuit.

While this invention has been described in connection with certain preferred embodiments, it is to be understood that the subject matter encompassed by way of this invention is not to be limited to those specific embodiments. On the contrary, it is intended for the subject matter of the invention to include all alternatives, modifications and equivalents as can be included within the spirit and scope of the following claims.

**Claims**

1. An optical receiver comprising:

a photodetector which converts an input optical signal to a photocurrent;
a first transistor whose base receives said photocurrent;
a first resistor connected to the collector of said first transistor;
a diode circuit comprising one diode or a plurality of series-connected diodes, said diode circuit being connected in parallel to said first resistor;
a second transistor whose base is connected to the collector of said first transistor;
a level shift circuit having a first terminal connected to the emitter of said second transistor;
a second resistor connected to a second terminal of said level shift circuit; and
a feedback resistor whose two terminals are connected to the base of said first transistor and said second terminal of said level shift circuit, respectively.

2. The optical receiver as claimed in claim 1, further comprising:

a third transistor whose base is connected to the emitter of said second transistor; and
a third resistor which is connected to the emitter of said third transistor.

3. The optical receiver as claimed in claim 1 or 2, wherein said photodetector comprises a PIN photodiode.

4. The optical receiver as claimed in claim 1 or 2, wherein said photodetector comprises an avalanche photodiode.

5. The optical receiver as claimed in any of claims 1 to 4, wherein said level shift circuit comprises a second diode.

6. The optical receiver as claimed in any of claims 1 to 4, wherein said level shift circuit comprises a fourth resistor.

7. The optical receiver as claimed in any of claims 1 to 6, wherein said diode circuit further comprises a resistor.

8. The optical receiver as claimed in any of claims 1 to 7, wherein said first and said second transistors are FETs, said emitters, collectors and bases of said transistors being sources, drains and gates, respectively.

9. The optical receiver as claimed in any of claims 2 to 7, wherein said first, second and third transistors are FETs, said emitters, collectors and bases of said transistors being sources, drains and gates, respectively.

10. An optical receiver comprising:

a photodetector which converts an input optical signal to a photocurrent; a first transistor whose base receives said photocurrent;
a first resistor connected to the collector of said first transistor;
a first diode connected in parallel to said first resistor;
a second transistor whose base is connected to the collector of said first transistor;
a level shift circuit having a first terminal connected to the emitter of said second transistor;
a second resistor connected to a second terminal of said level shift circuit;

a feedback resistor whose two terminals are connected to the base of said first transistor and said second terminal of said level shift circuit, respectively;

a third transistor whose base is connected to the emitter of said second transistor;

a third resistor which is connected to the emitter of said third transistor; and

a current source with its output current provided to said third resistor,

wherein reference current for said current source is adjustable using a variable resistor.

11. The optical receiver as claimed in claim 10, wherein said current source comprises a current mirror circuit.

12. The optical receiver as claimed in claim 10 or 11, wherein said level shift circuit comprises a second diode.

13. The optical receiver as claimed in any of claims 10 to 12, wherein said level shift circuit comprises a fourth resistor.

14. The optical receiver as claimed in any of claims 10 to 13, wherein said diode circuit further comprises a resistor.

15. An optical receiver comprising:

a photodetector which converts an input optical signal to a photocurrent;

a first transistor whose base receives said photocurrent;

a first resistor connected to the collector of said first transistor;

a first diode which is connected in parallel to said first resistor;

a second transistor whose base is connected to the collector of said first transistor;

a level shift circuit having a first terminal connected to the emitter of said second transistor;

a second resistor connected to a second terminal of said level shift circuit;

a feedback resistor whose two terminals are connected to the base of said first transistor and said second terminal of said level shift circuit, respectively;

a third transistor whose base is connected to the emitter of said second transistor;

a third resistor which is connected to the emitter of said third transistor; and

a differential amplifier comprising two emitter-coupled transistors and a current source connected to a connection point of said coupled emitters, wherein two input terminals are connected to the emitter of said third transistor and reference voltage source.

16. The optical receiver as claimed in claim 15, wherein said current source comprises a current mirror circuit.

17. The optical receiver as claimed in claim 15 or 16, wherein each of two emitters of said emitter-coupled transistors are connected via at least one resistor to said connection point.

18. The optical receiver as claimed in any of claims 15 to 17, wherein said level shift circuit comprises a second diode.

19. The optical receiver as claimed in any of claims 15 to 17, wherein said level shift circuit comprises a fourth resistor.

20. The optical receiver as claimed in any of claims 15 to 19, wherein said diode circuit further comprises a resistor.

# Figure1

# Figure2

# Figure3

# Figure4

# Figure5

# Figure6

# Figure7

# Figure8

**European Patent Office**

**EUROPEAN SEARCH REPORT**

Application Number

EP 98 11 9378

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 654 896 A (NIPPON ELECTRIC CO) 24 May 1995 | 1,5,7 | H03F3/08 |
| Y | * the whole document * | 10-12, 14,15, 17,18,20 | |
| X | TOUMAZOU C ET AL: "WIDEBAND LOW NOISE CMOS TRANSIMPEDANCE AMPLIFIER FOR GIGAHERTZ OPERATION" ELECTRONICS LETTERS, vol. 32, no. 13, 20 June 1996, pages 1194-1196, XP000599187 * page 1194 - page 1195; figures 1,2 * | 2,8,9 | |
| X | CENNINI P ET AL: "A WIDEBAND BIPOLAR TRANSIMPEDANCE PREAMPLIFIER FOR OPTICAL RECEIVER" NUCLEAR INSTRUMENTS & METHODS IN PHYSICS RESEARCH, SECTION - A: ACCELERATORS, SPECTROMETERS, DETECTORS AND ASSOCIATED EQUIPMENT, vol. A317, no. 1/02, 15 June 1992, pages 308-312, XP000413063 * page 309; figure 2 * | 3 | TECHNICAL FIELDS SEARCHED (Int.Cl.6) H03F |
| X | NORIO UENO ET AL: "INTEGRATED CIRCUITS FOR DIGITAL TRANSMISSION SYSTEMS" FUJITSU-SCIENTIFIC AND TECHNICAL JOURNAL, vol. 28, no. 2, 1 January 1992, pages 247-259, XP000312065 | 4 | |
| A | * page 257; figure 22B * | 5,6,12, 13,18,19 | |

-/--

The present search report has been drawn up for all claims

| Place of search | Date of completion of the search | Examiner |
|---|---|---|
| THE HAGUE | 17 December 1998 | Tyberghien, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 0 911 964 A1

**European Patent Office**

**EUROPEAN SEARCH REPORT**

Application Number

EP 98 11 9378

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | YUTAKA MATSUOKA ET AL: "INP/INGAAS DOUBLE-HETEROSTRUCTURE BIPOLAR TRANSISTORS FOR HIGH-SPEED ICS AND OEICS" SOLID STATE ELECTRONICS, vol. 38, no. 9, 1 September 1995, pages 1703-1709, XP000518984 | 6 | |
| A | * page 1708; figure 8 * | 14 | |
| Y | JOHN E ET AL: "DESIGN AND PERFORMANCE ANALYSIS OF INP-BASED HIGH-SPEED AND HIGH-SENSITIVITY OPTOELECTRONIC INTEGRATED RECEIVERS" IEEE TRANSACTIONS ON ELECTRON DEVICES, vol. 41, no. 2, 1 February 1994, pages 162-171, XP000478046 * page 167; figure 7 * | 10-12,14 | |
| Y | MEYER R G ET AL: "A WIDEBAND LOW-NOISE VARIABLE-GAIN BICMOS TRANSIMPEDANCE AMPLIFIER" IEEE JOURNAL OF SOLID-STATE CIRCUITS, vol. 29, no. 6, 1 June 1994, pages 701-706, XP000438076 * page 701; figure 1 * | 15,17, 18,20 | TECHNICAL FIELDS SEARCHED (Int.Cl.6) |

The present search report has been drawn up for all claims

| Place of search | Date of completion of the search | Examiner |
|---|---|---|
| THE HAGUE | 17 December 1998 | Tyberghien, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 98 11 9378

This annex lists the patent family members relating to the patent documents cited in the above-mentioned European search report.
The members are as contained in the European Patent Office EDP file on
The European Patent Office is in no way liable for these particulars which are merely given for the purpose of information.

17-12-1998

| Patent document cited in search report | Publication date | Patent family member(s) | Publication date |
|---|---|---|---|
| EP 0654896 A | 24-05-1995 | JP 2653018 B | 10-09-1997 |
| | | JP 7147520 A | 06-06-1995 |
| | | AU 679791 B | 10-07-1997 |
| | | AU 7902794 A | 01-06-1995 |
| | | US 5525929 A | 11-06-1996 |

EPO FORM P0459

For more details about this annex : see Official Journal of the European Patent Office. No. 12/82